# EUROPEAN PATENT SPECIFICATION

(11) **EP 0 824 237 B1**
(45) Date of publication and mention of the grant of the patent: **18.06.2003**
(21) Application number: 97830414.5
(22) Date of filing: 05.08.1997
(51) Int. Cl.: G06F 11/20, G06F 11/10, G06F 11/00

(54) **Audio RAM having error detection and correction function**
Audio-RAM mit Fehlerdetektion und Korrekturfunktion
Audio RAM ayant une fonction de détection et correction d'erreur

(30) Priority: 05.08.1996 IT RM960562
(43) Date of publication of application: 18.02.1998
(73) Proprietor: TEXAS INSTRUMENTS INC., Dallas, Texas 75243 (US); TEXAS INSTRUMENTS ITALIA S.p.A., 67051 Avezzano (AQ) (IT)
(72) Inventor: Pistilli, Pasquale, 67051 Avezzano (AQ) (IT); Di Zenzo, Maurizio, 00040 Roccapriora (RM) (IT)
(74) Representative: Taliercio, Antonio

(56) References cited:
- EP-A- 0 620 524
- WO-A-96/07969
- US-A- 4 485 471
- US-A- 4 942 556

## Description

The present invention relates to SIMM (Single In-Line Memory Module), and more particularly to a system for producing and testing SIMM memory modules by utilizing ARAM memory devices.

A SIMM (Single In-Line Memory Module) memory module for use in computers and similar low failure rate applications comprises ARAM (Audio DRAM) memory chips provided with internal address bus for each memory chip and an ASIC (Application Specific Integrated Circuit) module for outer interface, adapted to correcting the following failure categories:
A - failures affecting a single bit in a code word,
B - failures affecting multiple bits in a code word, each bit coming from a different memory chip,
C - failures affecting multiple bits in a code word in a single memory chip.

This invention broadly relates to ARAM memories and more particularly it concerns a system for utilizing such memories in any applications the specifications of which would require memories of better performances.

Still more particularly, this invention relates to a system for accommodating the failures of ARAM memories at least to such an extent as to enable them to be utilized in applications having more severe requirements, such as for instance the realization of SIMM modules for computers and like.

Audio DRAM memories, so-called ARAM memories, are dynamic DRAM memories, having a certain failure rate, namely they have failing bit locations in irregular or random positions. ARAM memories are utilized in audio applications, such as telephone transponders or answering machines, since their failure rate is such that a voice message stored therein can be played back without noticeable defects, in view of the fact that it is capable of accommodating any missing information, by means of integration and interpolation mechanisms.

Use of these memories in these applications, therefore, raises no problem, unless certain failure rate limits are overcome. For instance, they could not be utilized, should some rows or some columns be completely failing; in fact not even the human ear could accommodate such relevant lack of information by integration or interpolation mechanisms. The specifications of these memories, therefore, not only aim at establishing a maximum failure rate limit, but they also introduce the requirement that the failures should be located in random positions.

In addition to these requirements, even if 99% of the memory locations are properly operating, such ARAM memories could not be employed in conventional computer applications, due to the fact that the addresses of all failing bits are randomly dispersed within the memory array.

In other words, when a conventional ARAM memory is considered, it is conceivable to build up a correction system to correct any failing bit, by means of a correction system assimilable to a transmissive channel: that is a channel in a certain manner affected by noise. The problem of all failing memories can be coped with by considering the memory and consequently the scanning procedure of the memory like a bit string to be corrected by the same techniques as for transmissive channels.

But, while in transmissive channels, we may consider a mainly sequential string, in computer applications, the string to be considered is certainly random, rather than sequential. An error code should be studied, and therefore, adapted to cope with information that can be randomly stored in and retrieved from the concerned memory.

When the problem of applicability of ARAM memories to computers is to be solved, it is necessary to start from an analysis of the failure patterns of such memories.

Only when the failure topology of an exemplary population of ARAM memories, combined together so as to implement a code word (8 data bits and 4 redundancy bits), is detailedly analyzed, it is possible to define a circuitry adapted to correct any error containing data. By utilizing the probability theory, the probability to have a fully good word, or a word affected by a single error or by dual errors or by more than two errors is analyzed. After having analyzed the error probabilities, mathematical and cost evaluations are considered: in fact, if, on one hand, the solution of the problem is always mathematically possible, the involved costs could make such a solution unadvisable.

More specifically, the failure rate categories for each code word in a memory bank are as follows:
A - a failure rate involving a single bit in a code word;
B - a failure rate involving multiple bits in a code word, each bit coming from a different memory chip;
C - a failure rate involving multiple bits in a code word, occurring in a single memory chip.

As above mentioned, the broad solution of the problem is rather simple and several solution examples are available in the literature.

EP-A-0620524 discloses a memory module arranged for providing a predetermined functionality comprising a plurality of memory elements including at least one memory element having a reduced or potentially reduced performance and control circuitry capable of controlling the or each memory element, such that the predetermined functionality is produced using an ASIC providing ECC coding and decoding for correcting single bit failures in a code word and some multiple bit failure.

However, all known solutions mainly approach the problem to enhance the reliability of large size memory systems. Furthermore, such solutions are expensive and certainly are not adapted to be utilized in low cost applications.

From a specific view point, the prior art solutions are not suitable for utilization in SIMM (Single In-line Memory Modules) modules for computer (PC) applications.

It is the broad object of this invention to illustrate a proposal aimed at minimizing the redundancy needed for error correction (EC) purposes and at minimizing the costs connected with manufacturing an Application Specific Integrated Circuit (ASIC) designed to perform such function within the concerned SIMM memory module.

The solution provided by the present invention as defined by the claims, is to adopt an error correction code (ECC) of a multi-stage type, or, in other words, to establish a multi-stage procedure wherein, as hereinbelow discussed, each stage reduces the failure rate by one degree, thereby enabling the subsequent stage to operate in a lower complexity environment.

By recalling the above illustrated failure categories, the following procedure is carried out:
- since failures of type C are not very frequent (one out several hundred millions), it is conceivable to implement a small associative memory within the ASIC in order to store/retrieve both the address (as identified during the test procedure) and the data (as generated during operation) of all failing locations;
- failures of type B are coped with by converting any condition wherein *m* errors occur in one word into a condition wherein *m* words are found each including a single error; as it will be seen, a special circuitry is to be implemented within the ASIC and a special layout of the Printed Circuit Board (PCB) is to be designed in order to have each memory chip connected to a dedicated address bus;
- at this point, all failures of type A are definitely formed by single failing bits, which can be corrected by applying an error correction code (ECC) of normal conventional type, such as for instance a compact Hamming code.

Of course, at this point, a high number of failing bytes still remain due to the fact that, when, for instance, two memories are combined together, even if each of them is affected by an allowable failure rate, it is meaningfully likely that, upon combining them together, the allowable failure rate is overcome.

Since the error rate is anyway small and the errors are completely random, the basic idea of this invention is to scramble the addresses routed to one of the two memories. Under the term scrambling or reconditioning, the linear mathematical transformation function of the address area of one of the two memories with respect to the other should be understood, in a completely congruent and biunivocal manner, so that no address with two coincident failing bits can be found.

As it will be seen, the most convenient way to perform this address scrambling function provides for adding a constant to the concerned address and the result thereof is to eliminate all double error conditions, thereby returning to single error conditions.

Further details and advantages of this invention will be evident from the following specification by referring to the enclosed drawings wherein the preferred embodiment is shown by way of illustration and not by way of limitation.

In the drawings:
Figure 1 shows the architecture of a SIMM module according to this invention, wherein an internal address bus, specifically adapted to cooperate with each memory chip as well as an ASIC module for implementing the above mentioned functions are used;
Figure 2 shows the details of the ASIC module of Figure 1;
Figure 3 shows a computer test system for testing the SIMM modules according to this invention;
Figure 4 shows the details of the ASIC modules utilized in test equipment according to Fig. 3;
Figure 5 shows a block diagram of the address scrambling function, as performed in this invention;
Figure 6 shows a different embodiment of the interface ASIC circuit.

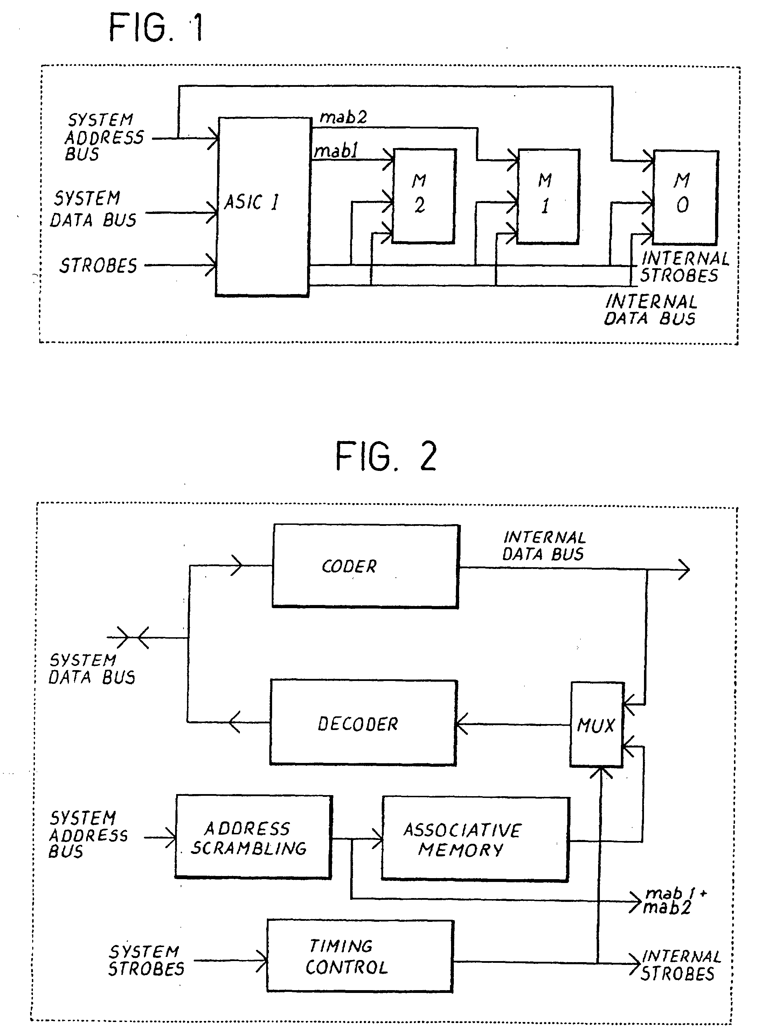

Aiming at detailedly explaining the above and by referring to Figures 1 and 2, the concerned ASIC module is designed for interfacing failing memory chips, particularly according to ARAM specifications, as mounted on 72 pin SIMM modules. The ASIC module selects a complete word or a single byte out of the four available ones at each access to the memory.

The implementations of the considered memory matrices or arrays are as follows:
- 1M x 32 by using twelve 1M x 4 chips,
- 1M x 32 by using three 1M x 16 chips,
- 2M x 32 by using six 1M x 16 chips,
- 1M x 32 by using two 1M x 16 chips and
   four 1M x 4 chips
- 4M x 4 by using twelve 4M x 4 chips

Two solutions are employed to correct the failing data or memory locations:
- a first solution is based upon the Hamming code, adapted to correct a single failing bit in a string of twelve bits (8 data bits and 4 parity bits);
- a second solution selects, for each row address, those chips having fully operative rows for this specific address, so as to supply the Host CPU with error free data words: no error correction or parity bit generation is furnished.

The two above mentioned procedures have some inherent limitations:
- the Hamming code is unable to handle more than one failing bit per byte;
- the row redundancy is unable to furnish error free data when all memory chips have failing rows at the same row address.

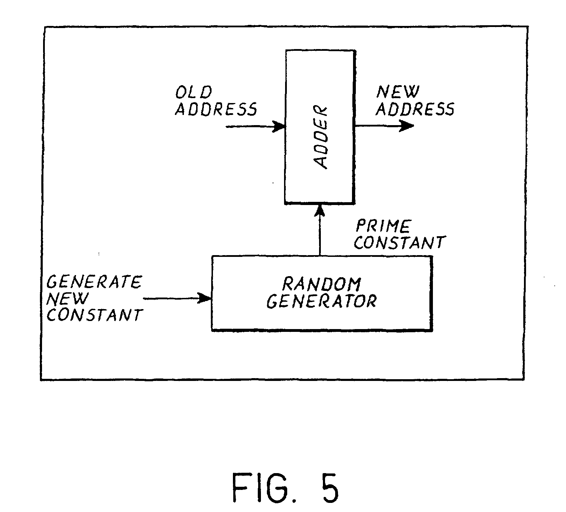

The ASIC circuit as proposed by this invention provides two particular mechanisms to overcome these limitations:
- scrambling the row addresses (as shown in Figure 5) in order to disperse the errors occurring in multiple rows at the same row address: this address scrambling step is carried out by utilizing two constants identified during the test procedure;
- inserting an associative memory into said ASIC circuit in order to materially replace any failing memory cell in the array. When the Host CPU selects one of these memory cells, the ASIC circuit carries out an internal storing (or retrieving) operation of data by utilizing the locations of the associative memory.

The ECC function is performed by delaying the access to the memory array in order to calculate the parity bits for each byte; if it is desired to minimize this delay, the initial write cycles of these memory cells are converted by said ASIC circuit into delayed write operations.

In redundancy mode, the data are retrieved from an on-chip SRAM memory in order to configure an internal multiplexer function aimed at enrouting the data to/from error free memory locations.

The input data word is divided into four bytes which are reconfigured into a six byte output word; it should be understood, however, that only four out of six bytes will be mapped in error free memory locations. The conversion from an initial write cycle to a delayed write cycle takes place in the redundancy mode, as well.

Furthermore, as it will be observed hereinafter, a special functionality is provided for testing the memory under exclusion of the ECC circuitry as well as for identifying any failing memory locations: the address scrambling constants and the associative memory locations are suitably programmed during the test procedure, based upon the failing location map or so-called fail map.

As far as the error correction functionality is concerned, when the proper selection bit is set in the Configuration Register, the concerned ASIC circuit calculates in each write cycle four parity bits in each byte, thereby generating a 36 bit data string and ignoring any parity bit furnished by the Host CPU. At each read cycle, the data are corrected by utilizing the parity bits and the external parity bit is furnished by the Host CPU. Access to a sihgle byte in a word is enabled in read or write mode without corrupting the remaining data bits.

As far as the row redundancy functionality is concerned, it can be utilized when the memory array implementation does not enable accessing to the single code words. In this case, the 32 bit external data word is converted by a multiplexer module into a 48 bit internal word and the data bits are stored into or retrieved from the memory array only by utilizing error free memory cells.

In read mode the above discussed ASIC circuit utilizes an on-chip SRAM memory (5 bit x 512) to select the four good bytes out of the six available ones, while, in write mode, said SRAM memory is utilized to reconvert the four data bytes into four good memory bytes out of the six available ones.

When it is desired to convert an ARAM memory into a valuable DRAM memory, it is necessary to locate all failing locations (mapping test) and this specific test operation is to be carried out in factory, in order to identify the row address scrambling constants, as well as all those addresses to be stored in the locations of the associative memory in order to make the memory array completely operative. Upon being generated, this information is to be stored in an external non-volatile memory comprising an EEPROM memory.

Aiming at shortening the test time, it is possible to utilize a specific ECC technique different from the one utilized within the SIMM module.

By utilizing this technique, it is possible:
- to prevent any error signal from being generated when the failure rate is in the specified range and the errors can be corrected by means of the ECC code at SIMM level;
- to interrupt the CPU by which the test program is carried out only when the concerned errors involve multiple chips and an address scrambling procedure is to be carried out;
- to prevent any error signal from being generated when multiple errors involve a single chip at a specific address, thereby automatically recording the failing address.

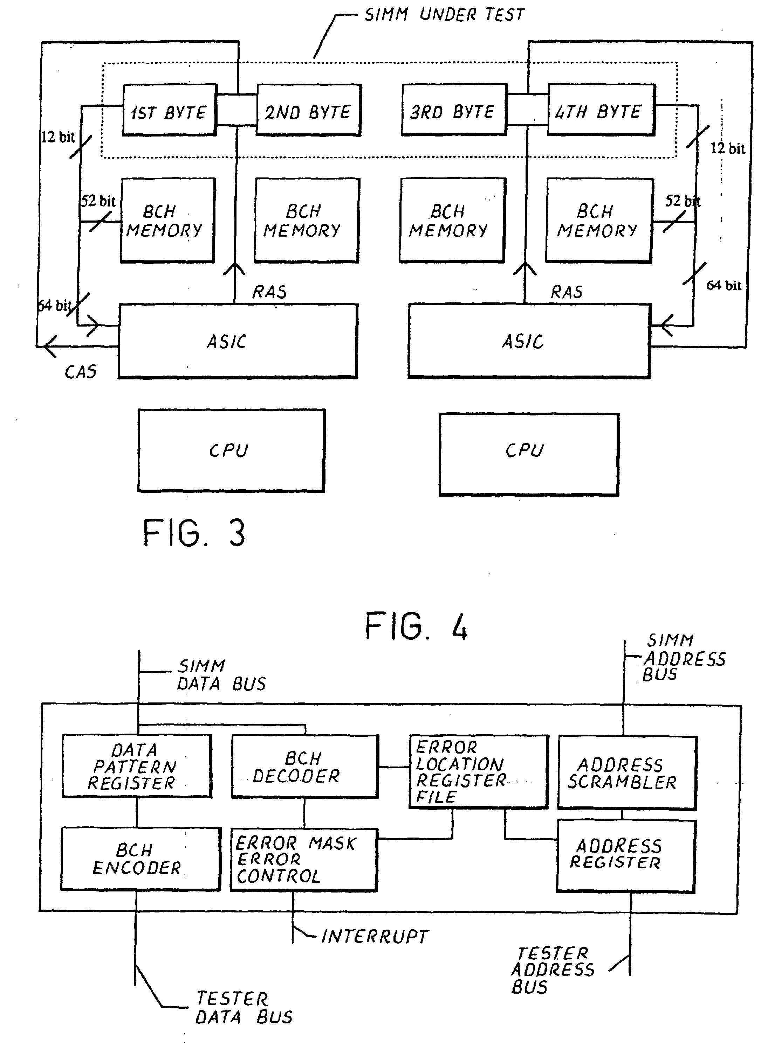

As it can be observed in Figure 3, a multiprocessor architecture is adopted, wherein the computer tests, in parallel, the four code word arrays of the SIMM module, while the ASIC module provided therein interfaces the CPU to the internal SIMM buses, by generating the data patterns and analyzing the read data so as to check their correctness. An illustration of the ASIC module utilized in the test equipment of Figure 3 is shown in Figure 4.

The test flow to be implemented comprises the following steps:
- a parametric test to identify the short circuit or open circuit conditions, both at connector level and at all test sites to access to networks not accessible through the connector pins;
- a mapping procedure to individuate the assembly of the constants and of the addresses of the associative memory by which the SIMM module is made operative at a coarse test level;
- a full operativeness test of the SIMM module at a convenient fitness level (it should be remarked that ARAM memories are not completely tested);
- a full re-analysis of all those units that cannot be mapped;
- a further mapping procedure for all those SIMM modules that do not overcome the operativeness test.

Summarizing the hardware aspects of this invention, a SIMM module has been heretofore described including an ASIC module designed as to broadly comprise:
- means to carry out an ECC coding function,
- means to carry out an ECC decoding function,
- means for implementing a parity generation function,
- means for implementing an address scrambling function,
- means for indicating an abnormality condition,
- means for implementing a scrambling function on external strobe signals so as to implement a correct timing sequence with inclusion of all delays due to said scrambling, coding and decoding operations,
- means for reading/writing data from/to a non-volatile memory (internal memory in the ASIC implementation, external memory for prototypization purposes),
- means to carry out a proper set up function for the constants utilized for the address scrambling function,
- means to carry out the generation function on-board and then within the SIMM reset module of the ASIC circuitry.

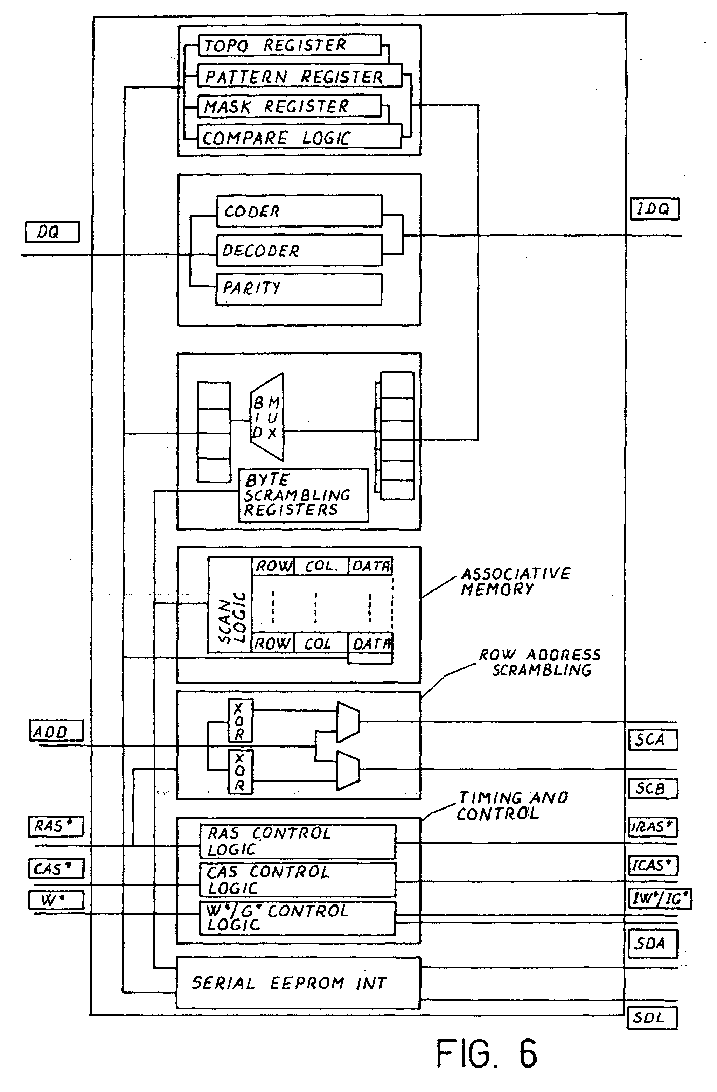

An alternatively embodiment of the interface ASIC circuit is illustrated in Figure 6.

The preferred embodiment of this invention has been hereinbefore explained, but it should be understood that those skilled in the art can made variations and changes therein without departing from the scope of this invention.

## Claims

1. A memory module for use in computers and similar low failure rate applications comprising ARAM (Audio DRAM) memory chips provided with an internal address bus for each memory chip and an ASIC (Application Specific Integrated Circuit) module for outer interface including error correction means for correcting the following failure categories:
A - failures affecting a single bit in a code word, and
B- failures which would be affect multiple bits in a code word, each bit coming from a different memory chip,
said ASIC module compris
- an ECC coder functional block,
- an ECC decoder functional block,
- an address reconditioning block, connected to the address bus of the system;
said memory module being **characterised in that** said ASIC module further comprises:
- a functional associative memory block,
- a functional multiplexer (mux) block, and
- a functional timing controlling block, to receive system strobe signals and to furnish internal strobe signals,
the input of said associative memory block being connected to the output of said address reconditioning block and the output of said associative memory block being coupled to the input of said decoder block via said multiplexer block,
such that failures affecting multiple bits in a code word in a single memory chip are corrected by said error correction means.

2. A memory module according to claim 1, **characterised in that** it further comprises means to correct failures of category B by scrambling addresses in order to disperse m errors which would otherwise occur in multiple chips at the same code word address to m code words each including one error.

3. A memory module as claimed in claim 1 or claim 2 and **characterised in that** it comprises means to correct the failures of category C involving multiple bits in a code word occurring in the same memory chip, by said associative memory storing/retrieving addresses identified during a test procedure and operation data relating to all failing locations.

4. The memory module as claimed in any preceding claim, wherein each memory chip comprises a dynamic random access memory device or a portion thereof.

5. The memory module as claimed in any preceding claim, wherein the memory module is in the form of a single-in-line memory module (SIMM).

## Patentansprüche

1. Speichermodul für die Verwendung in Computern und ähnlichen Anwendungen mit geringer Fehlerrate, das ARAM-Speicherchips (Audio-DRAM-Speicherchips), die mit einem internen Adressenbus für jeden Speicherchip versehen sind, und ein ASIC-Modul (anwendungsspezifisches integriertes Schaltungsmodul) für eine äußere Schnittstelle, das Fehlerkorrekturmittel zum Korrigieren der folgenden Fehlerkategorien enthält, umfaßt:
A - Fehler, die ein einzelnes Bit in einem Codewort betreffen und
B - Fehler, die mehrere Bits in einem Codewort betreffen, wobei jedes Bit von einem anderen Speicherchip stammt,
wobei das ASIC-Modul umfaßt:
- einen ECC-Codierungsfunktionsblock,
- einen ECC-Decodierungsfunktionsblock,
- einen Adressenwiederherstellungsblock, der mit dem Systemadressenbus verbunden ist, wobei das Speichermodul **dadurch gekennzeichnet ist, daß** das ASIC-Modul ferner umfaßt:
- einen funktionalen Assoziativspeicherblock,
- einen funktionalen Multiplexerblock (mux-Block) und
- einen funktionalen Zeitsteuerblock, der Systemtaktsignale empfängt und interne Taktsignale liefert,
wobei der Eingang des Assoziativspeicherblocks mit dem Ausgang des Adressenwiederherstellungsblocks verbunden ist und der Ausgang des Assoziativspeicherblocks über den Multiplexerblock mit dem Eingang des Decodierungsblocks gekoppelt ist,
so daß Fehler, die mehrere Bits eines einzigen Speicherchips in einem Codewort betreffen, durch die Fehlerkorrekturmittel korrigiert werden.

2. Speichermodul nach Anspruch 1, **dadurch gekennzeichnet, daß** es ferner Mittel umfaßt, die Fehler der Kategorie B durch Verwürfeln von Adressen korrigieren, um m Fehler, die andernfalls in mehreren Chips bei der gleichen Codewort-Adresse auftreten würden, auf m Codewörter zu verteilen, die jeweils einen Fehler enthalten.

3. Speichermodul nach Anspruch 1 oder Anspruch 2 und **dadurch gekennzeichnet, daß** es Mittel umfaßt, die die Fehler einer Kategorie C, die mehrere im selben Speicherchip auftretende Bits in einem Codewort betreffen, durch die Assoziativspeicher-Speicherungs-/Wiedergewinnungsadressen, die während einer Testprozedur identifiziert werden, und durch Operationsdaten, die mit allen Fehlerstellen in Beziehung stehen, korrigieren.

4. Speichermodul nach einem vorhergehenden Anspruch, bei dem jeder Speicherchip eine dynamische Schreib-Lese-Speichervorrichtung oder einen Teil hiervon umfaßt.

5. Speichermodul nach einem vorhergehenden Anspruch, wobei das Speichermodul die Form eines Single-Inline-Speichermoduls (SIMM) hat.

## Revendications

1. Module de mémoire destiné à être utilisé dans les ordinateurs et applications similaires à faible taux de défaillance comprenant des puces mémoire ARAM (Mémoire vive dynamique audio) muni d'un bus d'adresse interne pour chaque puce mémoire et un module CIAS (circuit intégré à application spécifique) pour interface externe incluant des moyens de correction d'erreur pour corriger les catégories de défaillance suivantes :
A- Défaillances affectant un seul bit dans un mot de code, et
B- Défaillances qui affecteraient des bits multiples dans un mot de code, chaque bit provenant d'une puce mémoire différente,
Ledit module CIAS comprenant :
- un bloc fonctionnel d'encodeur ECC *(code de correction d'erreur),*
- un bloc fonctionnel de décodeur ECC,
- un bloc de reconditionnement d'adresse, connecté au bus d'adresses du système ;
ledit module de mémoire étant **caractérisé en ce que** ledit module CIAS comprend en outre :
- un bloc fonctionnel de mémoire associative,
- un bloc fonctionnel de multiplexeur (mux), et
- un bloc fonctionnel de contrôle de synchronisation, pour recevoir des signaux d'échantillonnage du système et pour fournir des signaux d'échantillonnage internes,
l'entrée du bloc de mémoire associative étant connectée à la sortie dudit bloc de reconditionnement d'adresse et la sortie dudit bloc de mémoire associative étant couplée à l'entrée dudit bloc de décodeur via ledit bloc de multiplexeur,
de sorte que les défaillances affectant des bits multiples dans un mot de code dans une seule puce mémoire sont corrigées par lesdits moyens de correction d'erreur.

2. Module de mémoire selon la revendication 1, **caractérisé en ce qu'**il comprend en outre des moyens pour corriger des défaillances de catégorie B en brouillant des adresses afin de disperser m erreurs qui se produiraient sinon dans des puces multiples à la même adresse de mot de code vers m mots de code incluant chacun une erreur.

3. Un module de mémoire selon la revendication 1 ou la revendication 2, et **caractérisé en ce qu'**il comprend des moyens pour corriger les défaillances de catégorie C impliquant des bits multiples dans un mot de code se produisant dans la même puce mémoire, par des adresses de stockage / extraction de ladite mémoire associative identifiées au cours d'une procédure de tests et des données d'exploitation concernant tous les emplacements défaillants.

4. Module de mémoire selon l'une quelconque des revendications précédentes, dans lequel chaque puce mémoire comprend un dispositif de mémoire à accès aléatoire dynamique ou une partie de celui-ci.

5. Module de mémoire selon l'une quelconque des revendications précédentes, dans lequel le module de mémoire est sous la forme d'un module de mémoire à simple rangée de connexions (SIMM).
